# EUROPÄISCHE PATENTSCHRIFT

(11) **EP 3 362 408 B1**
(45) Veröffentlichungstag und Bekanntmachung des Hinweises auf die Patenterteilung: **10.07.2019**
(21) Anmeldenummer: 16784427.3
(22) Anmeldetag: 11.10.2016
(51) Int. Cl.: C01B 33/035

(54) **REAKTOR ZUR ABSCHEIDUNG VON POLYKRISTALLINEM SILICIUM**
REACTOR FOR DEPOSITING POLYCRYSTALLINE SILICON
RÉACTEUR POUR DÉPOSER DU SILICIUM POLYCRISTALLIN

(30) Priorität: 14.10.2015 DE 102015219925
(43) Veröffentlichungstag der Anmeldung: 22.08.2018
(73) Patentinhaber: Wacker Chemie AG, 81737 München (DE)
(72) Erfinder: KRAUS, Heinz, 84367 Zeilarn (DE); KUTZA, Christian, 84539 Ampfind (DE)
(74) Vertreter: Belz, Ferdinand
(86) Internationale Anmeldenummer: PCT/EP2016/074317
(87) Internationale Veröffentlichungsnummer: WO 2017/064048

(56) Entgegenhaltungen:
- EP-A2- 2 077 252
- WO-A1-2007/032518
- WO-A1-2010/141551
- DE-A1- 19 847 647
- US-A1- 2013 302 528
- US-B1- 6 258 900

## Beschreibung

Die Erfindung betrifft einen Reaktor zur Abscheidung von polykristallinem Silicium.

Hochreines polykristallines Silicium (Polysilicium) dient als Ausgangsmaterial zur Herstellung von einkristallinem Silicium für Halbleiter nach dem Czochralski (CZ)- oder Zonenschmelz (FZ)-Verfahren, sowie zur Herstellung von ein- oder multikristallinem Silicium nach verschiedenen Zieh- und Gieß-Verfahren zur Produktion von Solarzellen für die Photovoltaik.

Polysilicium wird üblicherweise mittels des Siemens-Verfahrens hergestellt. Dabei wird ein Reaktionsgas umfassend eine oder mehrere Silicium enthaltende Komponenten und gegebenenfalls Wasserstoff in einen Reaktor umfassend durch direkten Stromdurchgang erhitzte Trägerkörper eingeleitet, wobei sich an den Trägerkörpern Silicium in fester Form abscheidet. Als Silicium enthaltende Komponenten werden bevorzugt Silan (SiH₄), Monochlorsilan (SiH₃Cl), Dichlorsilan (SiH₂Cl2), Trichlorsilan (SiHCl₃), Tetrachlorsilan (SiCl₄) oder Mischungen der genannten Stoffe eingesetzt.

Das Siemens-Verfahren wird üblicherweise in einem Abscheidereaktor (auch "Siemens-Reaktor" genannt) durchgeführt. In der gebräuchlichsten Ausführungsform umfasst der Reaktor eine metallische Grundplatte und eine kühlbare Glocke, die auf die Grundplatte gesetzt ist, so dass ein Reaktionsraum im Inneren der Glocke entsteht. Die Grundplatte ist mit einer oder mehreren Gaseinlassöffnungen und einer oder mehreren Abgasöffnungen für die abgehenden Reaktionsgase sowie mit Halterungen versehen, mit deren Hilfe die Trägerkörper im Reaktionsraum gehalten und mit elektrischen Strom versorgt werden.

Jeder Trägerkörper besteht meistens aus zwei dünnen Filamentstäben und einer Brücke, die in der Regel benachbarte Stäbe an ihren freien Enden verbindet. Am häufigsten werden die Filamentstäbe aus ein- oder polykristallinem Silicium gefertigt, seltener kommen Metalle bzw. Legierungen oder Kohlenstoff zum Einsatz. Die Filamentstäbe stecken senkrecht in am Reaktorboden befindlichen Elektroden, über die der Anschluss an die Stromversorgung erfolgt. An den erhitzten Filamentstäben und der waagrechten Brücke scheidet sich hochreines Polysilicium ab, wodurch deren Durchmesser mit der Zeit anwächst. Nachdem der gewünschte Durchmesser erreicht ist, wird der Prozess beendet.

Zur Herstellung von Polysilicium werden standardmäßig Abscheidereaktoren eingesetzt, bei denen im unteren Teil, der sog. Bodenplatte, über Düsen das Reaktionsgas eingedüst wird. Eine Einleitung des Reaktionsgases im oberen Teil des Reaktors mittels Düsen ist allerdings ebenso möglich.

Ebenfalls wird entstehendes Abgas oft über eine oder mehrere Öffnungen im Reaktorboden, aber auch über die Reaktorhaube, aus dem Reaktor abgeführt.

Da eine gleichmäßige Verteilung des Zugases für die gleichmäßige Abscheidung an den Stäben wichtig ist, wird das Gas üblicherweise über mehrere Düsen zugeführt.

Eine solche Verteilung des Zugases kann entweder mittels einer Vielzahl von einzelnen Zugasleitungen jeweils mit direktem Anschluss an die einzelnen Zugasdüsen oder über einen Gasverteiler, z.B. einen ringförmigen oder einen anders gearteten Gasverteiler in Reaktornähe meist unterhalb der Reaktorbodenplatte, mit mehreren Anschlüssen für die einzelnen Zugasdüsen, realisiert werden.

Während des Abscheideprozesses kann es zur Rissbildung in den wachsenden Siliciumstäben kommen. Als Folge können Siliciumsplitter verschiedener Größe in die Zu- und Abgasöffnungen hineinfallen und die Gasleitungen bzw. Gasverteiler blockieren. Im schlimmsten Fall können alle Stäbe zusammenbrechen, wobei sehr große Siliciumstücke in die Ein- und Austrittsöffnungen fallen.

Beim Zugas führt eine solche Blockierung zu einer ungleichmäßigen Verteilung bzw. falscher Dosierung des Zugases und beim Abgas kann es durch Verblockung zu einem unerwünschten Druckanstieg im Reaktor kommen.

Aus diesem Grund müssen die Siliciumstücke spätestens vor der Folgecharge entfernt werden. Siliciumstücke lassen sich meist nur unter größerem Aufwand (z.B. händisch oder mit Greifwerkzeug, Staubsauger) entfernen. Diese Prozedur ist umständlich und langwierig (d.h. höhere Rüstzeiten) und führt auch nicht immer zum Erfolg, da sehr große Stücke manchmal zu sperrig für das Greifwerkzeug sind und mit dem Staubsauger nicht abgesaugt werden können.

EP2077252 offenbart einen Reaktor zur Abscheidung von polykristallinem Silicium, der seitlich und nach oben durch eine Reaktorwand und nach unten durch eine Bodenplatte begrenzt ist, umfassend mehrere auf der Bodenplatte angebrachte, durch direkten Stromdurchgang beheizbare Filamentstäbe, ein durch eine oder mehrere Öffnungen der Bodenplatte geführtes Zugassystem zum Einbringen eines Silicium enthaltenden Reaktionsgasgemisches in den Reaktor, und ein durch ein oder mehrere Öffnungen der Bodenplatte geführtes Abgassystem zum Abführen von Abgas aus dem Reaktor. Das Dokument offenbar auch eine Mehrzahl von Düsen verteilt auf der Bodenplatteoberfläche, die das Reaktionsgasgemisch gleichmäßig in den Reaktor zuführen.

DE19847647 offenbart einen Wirbelschichtreaktor, in dem die Gasverteilung beim Eintritt durch einen Gasverteilerboden geführt wird und der Auslass für das Gas auch mit Filterelementen ausgerüstet ist. Die Filterelemente befinden sich in Innerraum des Reaktors.

WO 2014/166711 A1 offenbart einen Gasverteiler und einen Abgassammler, die aus zwei oder mehreren Teilstücken zusammengesetzt und mit lösbaren Mitteln (z.B. Flansche) gasdicht miteinander verbunden sind. Dies ermöglicht das Entfernen der hineingefallenen Si-Stücke durch die vereinfachte Entfernung und Reinigung des Gasverteilers bzw. Abgassammlers..

Trotz der möglichen vereinfachten Reinigung des Gasverteilers bzw. des Abgassammlers, da ggf. nur der verunreinigte Teil des in Segmentbauweise ausgestalteten Schutzelements abmontiert und gereinigt werden muss, sind die Demontage-, Reinigungs- und Wiedermontagevorgänge mit einem erheblichen zeitlichen Aufwand verbunden. Die erforderliche Splittersuche und -entfernung führt zu einer Minderausbringung wegen Nichterreichen des Zieldurchmesser und erhöhter Chargenwechselzeit.

Da der Trend zu größeren Abscheideanlagen mit ausbringungsstarken Prozessen geht, die größere Feedmengen und damit Zugasdüsen mit größerem Durchmesser erforderlich macht, wird diese Problematik noch verschärft. Aufgrund der großen Düsendurchmesser können Siliciumsplitter noch leichter durch die Düsen in das Zugassystem gelangen und dieses partiell blockieren. Durch das partiell blockierte Zugassystem werden die verschiedenen Düsen ungleichmäßig mit Feed versorgt.

Die Abgasöffnungen in der Bodenplatte sind in der Regel größer als die Durchmesser der Zugasdüsen. Weiterhin haben die Bodenplatten in der Regel mehrere Abgasöffnungen, die in der Regel symmetrisch in der Bodenplatte angeordnet sind. Aufgrund der Größe der Abgasöffnungen können ebenfalls Si- Splitter und Brocken, die durch umgefallene Chargen während der Abscheidung, während dem Abkühlen der Stäbe nach Ende des Abscheideprozesses oder während des Ausbaus der Stäbe aus dem Reaktor entstehen, in das Abgassystem gelangen und eine oder mehrere Abgasleitungen teilweise blockieren. Diese Si-Teile können eine Länge von 0 - 300 mm und einen Querschnitt von 0 bis zum Querschnitt der Abgasöffnung haben.

Blockierungen oder teilweise Blockierungen in Zu-und Abgasleitungen können zu ungleichmäßiger Strömung im Reaktor und damit zu ungleichmäßigem Durchmesserwachstum der einzelnen Polysiliciumstäbe, unterschiedlich starkem Popcornwachstum bis hin zum Ausfall der Anlage während des Abscheideprozesses führen. Wenn mehrere Abgasöffnungen vorhanden sind und wenn eine oder mehrere Abgasöffnungen teilweise verstopft sind, wird die Gasströmung im Reaktor asymmetrisch.

Splitter oder Si-Brocken in der Zugasleitung beeinflussen die Fluiddynamik im Reaktor durch ungleichmäßige Verteilung des Zugases auf die einzelnen Düsen und führen damit zu einem asymmetrischen Strömungsprofil im Abscheidereaktor. Si-Brocken in den Abgasöffnungen oder Abgasleitungen führen ebenfalls zu einem asymmetrischen Strömungsprofil im Abscheidereaktor.

Eine asymmetrische Reaktorströmung senkt die Prozessstabilität durch Chargenausfall während des Abscheideprozesses (umfallende Stabpaare). Umgefallene Stabpaare müssen zu minderwertigerem Produkt wegen Verunreinigungen abgewertet werden oder aufwendig gereinigt werden. Stabstücke mit zu tiefem Popcornwachstum müssen zu einem minderwertigeren Produkt abgewertet werden, da der Popcornanteil ein Qualitätskriterium und Bestandteil der Produktspezifikation ist. Der dickste Stabdurchmesser bestimmt den Abstelldurchmesser der Charge. Dünnere Stäbe innerhalb einer Charge reduzieren somit die Anlagenausbringung und erhöhen die Herstellkosten.

CN 100425532 C beschreibt ein Zugasleitungsrohr, welches in den Reaktor hinein ragt. Das Zugasleitungsrohr besitzt mehrere seitliche Öffnungen in unterschiedlichen Höhen um die Siliciumstäbe mit Feed zu versorgen. Da keine vertikale Öffnung vorhanden ist, können keine Splitter in das Zugassystem gelangen. Eine solche Konfiguration ist jedoch nachteilig, da auf eine vertikale Gasströmung bei der Herstellung von Polysilicium .nicht verzichtet werden kann. Weiterhin nachteilig ist die Länge des Zugasleitungsrohres, welches thermisch und chemisch derart stark belastet wird, dass es zu Korrosion des Zugasleitungsrohres und infolgedessen zu einer Verunreinigung des hergestellten Polysiliciums kommt.

CN 203890069 U beschreibt eine Vorrichtung zum Absetzen von Staub aus dem Abgas. Es besteht aus zwei ineinander gesteckten Teilen aus Graphit und liegt auf der Bodenplatte über der Abgasöffnung und ragt in den Reaktorraum. Der äußere Teil hat am Umfang eine Vielzahl von Öffnungen durch die das staubhaltige Abgas strömt. Der Staub sedimentiert zwischen äußerem und innerem Teil.

CN 103896270 A beschreibt ein rohrförmiges, am oberen Ende geschlossenes Einbauteil aus Graphit mit seitlichen Bohrungen, das sich vor einem Rohrbündelwärmetauscher im Abgassystem einer Abscheideanlage zur Abscheidung von polykristallinem Silicium befindet. Das Einbauteil soll die anschließende Rohrströmung vergleichmäßigen und abrasive Partikel (amorphes Silicium) vom Wärmetauscher abhalten und dadurch Korrosion des Wärmetauschers in Form von Abrasion vermeiden.

Bei den beiden zuletzt genannten Veröffentlichungen besteht das Problem, dass die Graphitteile größeren herabfallenden Si-Stücken mechanisch nicht standhalten. Die Einbauteile werden zerstört, so dass Si-Stücke in die Abgasleitung gelangen.

Aus dieser Problematik ergab sich die Aufgabenstellung der Erfindung.

Die Aufgabe wird gelöst durch einen Reaktor zur Abscheidung von polykristallinem Silicium, der seitlich und nach oben durch eine Reaktorwand und nach unten durch eine Bodenplatte begrenzt ist, umfassend mehrere auf der Bodenplatte angebrachte, durch direkten Stromdurchgang beheizbare Filamentstäbe, ein durch eine oder mehrere Öffnungen der Bodenplatte geführtes Zugassystem zum Einbringen eines Silicium enthaltenden Reaktionsgasgemisches in den Reaktor, und ein durch ein oder mehrere Öffnungen der Bodenplatte geführtes Abgassystem zum Abführen von Abgas aus dem Reaktor, dadurch gekennzeichnet, dass Zugassystem und/oder Abgassystem wenigstens ein Schutzelement umfassen, das aus Metall, aus Keramik oder aus CFC besteht, das Öffnungen oder Maschen aufweist, wobei die Öffnungen und die Maschen des Schutzelements so konfiguriert sind, dass unterhalb des Schutzelements nur Siliciumteile in das Zugas- oder Abgassystem gelangen können, die sich durch Spülen aus dem Zugas- oder Abgassystem entfernen lassen.

Unter dem Zugassystem sind eine oder mehrere Düsen sowie eine oder mehrere jeweils mit einer Düse verbundene Zugasleitungen oder ein mit den Düsen verbundener Gasverteiler zu verstehen. Zugasleitung und Düse können also jeweils direkt miteinander verbunden sein. Es kann jedoch auch ein Gasverteiler unterhalb der Bodenplatte vorgesehen sein, der mehrere Anschlüsse für die einzelnen Zugasdüsen aufweist. Düsen und Zugasleitungen werden durch Öffnungen der Bodenplatte geführt und auf der Bodenplatte befestigt. Es sind jedoch auch andere Konfigurationen denkbar, z.B. eine Kombination aus einem Gasverteiler und einzelnen mit Düsen verbundenen Zugasleitungen.

Unter dem Abgassystem sind eine oder mehrere Öffnungen in der Bodenplatte und die an diesen Öffnungen angeschlossenen Abgasleitungen zu verstehen.

In einer Ausführungsform umfasst das Abgassystem einen Abgassammler, der mit einer oder mehreren Abgasöffnungen der Bodenplatte kommunizierend verbunden ist. Falls die Bodenplatte drei Abgasöffnungen aufweist, kann der Abgassammler ebenfalls drei Gaseintrittsöffnungen aufweisen, die jeweils mit einer der Abgasöffnungen des Reaktors kommunizierend verbunden sind. Es sind jedoch auch andere Konfigurationen denkbar, z.B. eine Kombination aus Abgassammlern und einzelnen Abgasleitungen.

Im Zugassystem kann das Schutzelement also in die Düse oder in die Zugasleitung eingebracht werden. Jede einzelne Düse oder jede separate Zugasleitung ist mit einem Schutzelement auszustatten.

In einer Ausführungsform der Erfindung handelt es sich bei dem Schutzelement um ein Gitter, das in den Querschnitt einer Zugasleitung oder Düse eingebracht ist.

Das Gitter kann in einem Abstand von 0 - 500 mm vom Ende der Zugasleitung entfernt sein. Das Ende der Zugasleitung soll definitionsgemäß durch die Oberkante der Düse gegeben sein.

Das Gitter kann somit in der Zugasleitung oder an der Oberseite, der Unterseite oder in der Düse befestigt oder verschraubt sein.

Das Gitter kann eine ebene Fläche oder eine gekrümmte Form aufweisen.

Das Gitter kann aus Maschengewebe oder einem Grundkörper mit Löchern bestehen. Die Form der Löcher kann rund, quadratisch oder jede andere beliebige Form haben. Bevorzugt wird eine runde oder eine quadratische Form.

Der Grundkörper des Gitters kann in unterschiedlichen Geometrien ausgeführt sein.

Mögliche Geometrien sind: ebene Scheibe, kugel- oder ovalförmig, konisch oder zwei- oder dreidimensional gekrümmt.

In einer bevorzugten Ausführungsform handelt es sich um eine ebene Scheibe.

Jede Ausführungsform des Gitters kann in unterschiedlichen Winkeln zur Strömungsrichtung in der Düse fixiert werden.

Der Winkel kann 0-80° betragen.

In einer Ausführungsform ist das Gitter an der Unterseite der Düse befestigt. Als Unterseite wird die Seite verstanden, die mit der Zugasleitung verschraubt wird.

Mögliche Befestigungsarten des Gitters an der Düse sind: schweißen, löten, verschrauben, stecken oder klemmen.

Ebenso kann das Gitter bereits bei der Herstellung der Düse aus einem Vollmaterial herausgearbeitet worden sein.

In einer bevorzugten Ausführungsform erfolgt die Befestigung des Gitters an der Düse durch Schweißen. Es ist von Vorteil, Düse und Gitter aus dem gleichen Werkstoff zu fertigen.

Als Werkstoffe für das Gitter eignen sich alle gegen heiße HCl- und Chlorsilangemische beständigen Metalle (Edelstähle, Edelmetalle), Keramiken und CFC (Kohlenstofffaserverstärkter Kohlenstoff).

Die Maschenweite (a) des Gitters liegt zwischen 2-15 mm, bevorzugt 3-10 mm und besonders bevorzugt 3-7 mm. Die Stegbreite (b) des Gitters liegt zwischen 0,5-5 mm. Bevorzugt 0,5-3 mm, besonders bevorzugt 0,5-2 mm.

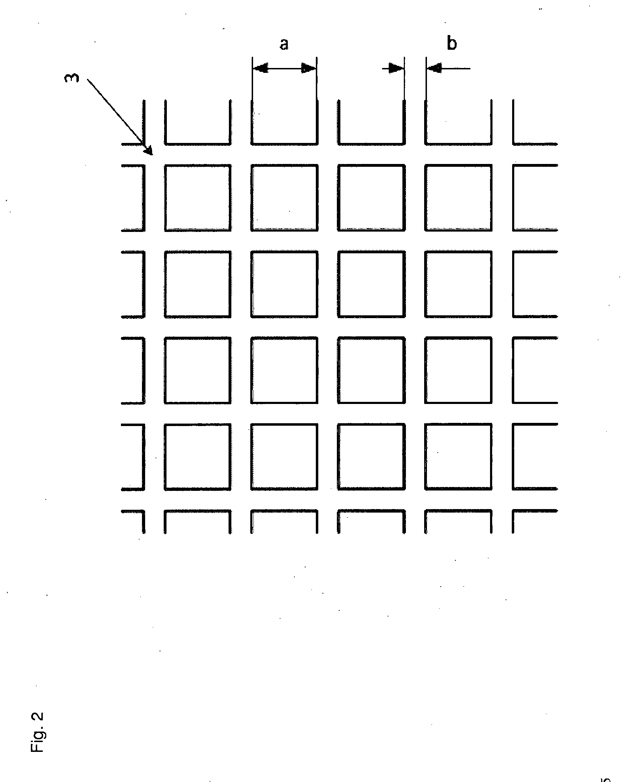

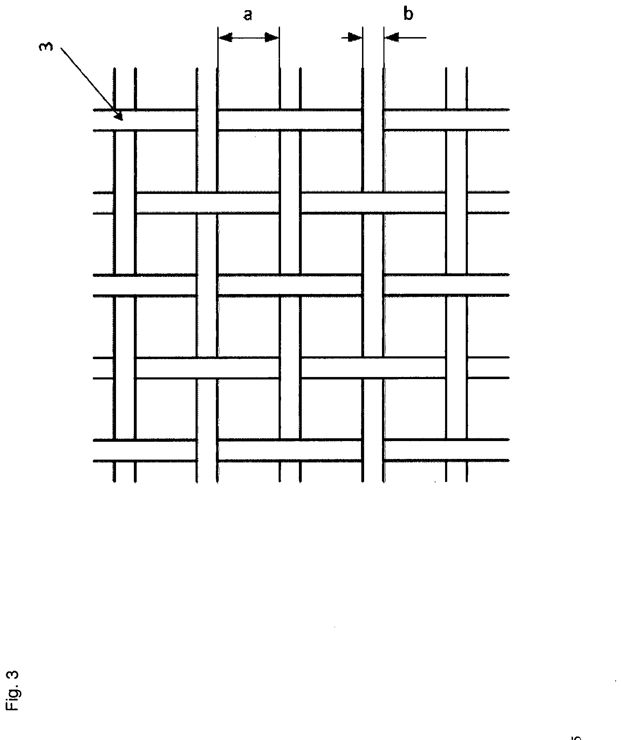

Das Verhältnis der Summe aller Lochflächen zur Gesamtfläche des Gitters K1 sollte zwischen 0,2 und 0,8 liegen. Unter der Gesamtfläche des Gitters ist die Summe aller Lochflächen plus die Summe aller Stegflächen zu verstehen (vgl. Fig. 2 und Fig. 3 mit Definition Stegbreite).

In einer bevorzugten Ausführungsform beträgt das Verhältnis K1 0,3 - 0,7.

In einer besonders bevorzugten Ausführungsform beträgt das Verhältnis K1 0,4-0,65.

In einer anderen Ausführungsform handelt es sich bei dem Schutzelement um ein in die Abgasleitung eingesetztes Abgassieb. Das Abgassieb soll vermeiden, dass Abgasleitungen durch Si-Teile blockiert werden.

Das Abgassieb kann in der Abgasleitung nach der Bodenplatte oder in den Abgasöffnungen der Bodenplatte platziert sein.

Im einfachsten Fall ist das Abgassieb eine Lochscheibe zwischen den Flanschen in der Abgasleitung.

Vorzugsweise hat das Abgassieb die Form eines Korbes, der in die Abgasöffnung der Bodenplatte eingehängt ist. Dies hat den Vorteil der leichten Zugänglichkeit und Austauschbarkeit. Zu diesem Zweck ist es von Vorteil, wenn der Korb an dessen oberen Ende eine Verbreiterung zur Auflage auf der Bodenplatte aufweist.

In einer Ausführungsform ragt in die Abgasöffnung ein Abgaskorb, der nach oben zur Bodenplatte hin offen, nach unten zur Abgasleitung hin geschlossen und dessen Wandung mit Löchern versehen ist.

Der Abgaskorb kann zylindrisch sein oder nach unten konisch zulaufen. Er kann auch jede andere beliebige Form haben, die in die Abgasöffnung passt.

Bevorzugt ist eine nach unten konisch zulaufende Form.

Die Fläche der einzelnen Löcher des Abgaskorbes liegt zwischen 15-225 mm². Bevorzugt 15-150 mm², besonders bevorzugt 15-100 mm².

Das Verhältnis K2 der Summe aller Lochflächen zur in die Abgasöffnung ragenden Oberfläche des Abgaskorbes sollte zwischen 0,2 und 0,9 liegen. Die in die Abgasöffnung ragende Oberfläche des Abgaskorbes ist die Summe aller Lochflächen plus die Summe aller Nichtlochflächen.

In einer bevorzugten Ausführungsform beträgt das Verhältnis K2 0,3 - 0,8.

In einer besonders bevorzugten Ausführungsform beträgt das Verhältnis K2 0,5-0,8.

Als Werkstoffe für das Abgassieb bzw. den Abgaskorb eignen sich alle gegen heiße HCl- und Chlorsilangemische beständigen Metalle (Edelstähle, Edelmetalle), Wolfram, Keramiken wie ZrO2, mit Yttriumoxid stabilisiertes ZrO2, Si3N4, SiC Siliciumcarbid und CFC.

Bevorzugt ist der Einsatz von CFC, ZrO₂ und mit Yttrium stabilisiertes ZrO₂.

Abgassieb/Abgaskorb können aus einem Teil bestehen oder aus mehreren Einzelteilen zusammengefügt sein, z.B. durch Schweißen, Stecken, Schrauben, Klemmen oder mit Stiften fixieren.

Bevorzugt sind Abgassieb/Abgaskorb einteilig.

In einer Ausführungsform der Erfindung werden die zuvor beschriebenen Ausführungen von Schutzelementen im Zugassystem und die zuvor beschriebenen Ausführungen von Schutzelementen im Abgassystem miteinander kombiniert.

Es ist also besonders bevorzugt, wenn sowohl das Zugassystem als auch das Abgassystem solche Schutzelemente aufweisen.

In einer Ausführungsform umfasst jede Düse oder alternativ jede mit einer Düse verbundene Zugasleitung ein Gitter wie zuvor beschrieben, wobei gleichzeitig in jede Abgasöffnung der Bodenplatte ein Abgaskorb eingehängt ist.

Die Erfindung bezieht sich auch auf ein Verfahren zur Herstellung von polykristallinem Silicium, umfassend Einleiten eines Reaktionsgases enthaltend eine Silicium enthaltende Komponente und Wasserstoff in einen Reaktor nach einer oder mehreren der zuvor beschriebenen Ausführungsformen, enthaltend mehrere Filamentstäbe, die jeweils mittels einer Elektrode mit Strom versorgt und damit durch direkten Stromdurchgang auf eine Temperatur aufgeheizt werden, bei der sich polykristallines Silicium auf den Filamentstäben abscheidet.

Die Erfindung ermöglicht es somit, Siliciumsplitter/ -bruchstücke, die größer sind als die Öffnungen in den Schutzelementen im Zugas- und Abgassystem zu vermeiden bzw. Siliciumsplitter/ -bruchstücke, die kleiner sind als die Öffnungen in den Schutzelementen durch einfaches Rückspülen zu entfernen.

Damit sind gleichmäßige Fluidverteilungen im Zugassystem sowie im Reaktor erreichbar. Eine symmetrische Reaktorströmung hat ein gleichmäßiges Aufwachsen der Stabpaare und eine einheitliche Morphologie der einzelnen Stabpaare zur Folge.

Dagegen werden bei asymmetrischer Reaktorströmung unterschiedlich dicke Stäbe mit unterschiedlicher Morphologie aufwachsen. Der Abstelldurchmesser einer Charge ist durch das dickste Stabpaar begrenzt. Bei gleichmäßig dicken Stabpaaren können höhere Chargengewichte erreicht werden, was eine höhere Ausbringung und niedrigere Kosten zur Folge hat.

Bei zu schlechter Morphologie (zu poröses Material mit zu hohem Popcornanteil) muss das Silicium teilweise zu einem minderwertigen Produkt abgewertet werden. Diese Abwertung entfällt bei gleichmäßiger Morphologie, da die Morphologie dann über den Abscheideprozess gezielt eingestellt werden kann. Unter Morphologie wird die Kompaktheit und die Oberflächen- und Bulkbeschaffenheit in Bezug auf unterschiedlich ausgeprägtes Popcorn verstanden.

Vorteilhaft ist, dass die Rüstzeit verkürzt ist, da Splittersuche durch z.B. Endoskopieren und zeitaufwendiges Entfernen der Splitter im Chargenwechsel entfällt.

Die bezüglich der vorstehend aufgeführten Ausführungsformen des erfindungsgemäßen Reaktors angegebenen Merkmale können entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

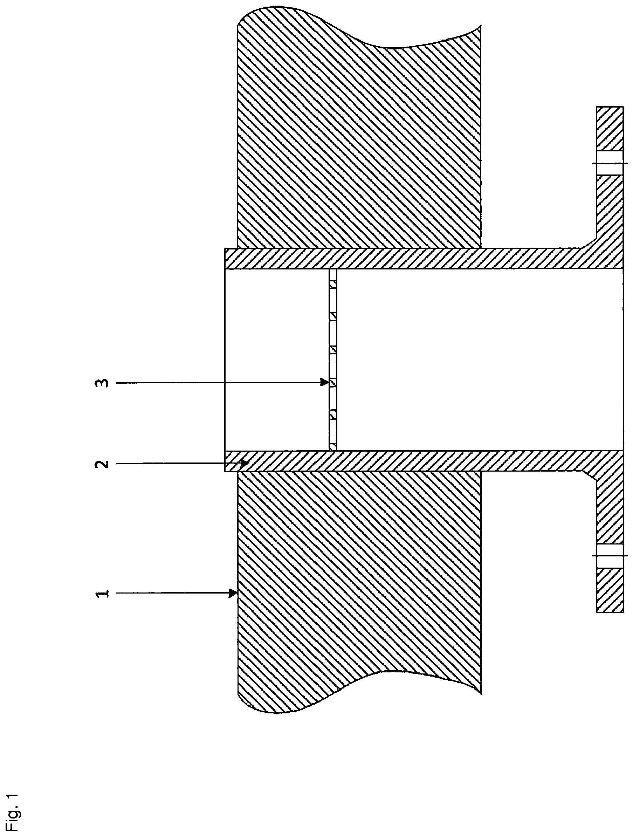

Die Erfindung wird im Folgenden zusätzlich anhand von **Fig. 1 - 8** erläutert.

### Liste der verwendeten Bezugszeichen

- **1**: Bodenplatte
- **2**: Zugasleitung
- **3**: Gitter
- **4**: Verschraubung
- **5**: Befestigungsring für Gitter
- **6**: Stifte zur Gitterfixierung
- **7**: Düse
- **8**: Abgasöffnung
- **9**: Abgasleitung mit Kühlung
- **10**: Abgaskorb
- **11**: Löcher im Abgaskorb

- **a**: Maschenweite
- **b**: Stegbreite

### Kurzbeschreibung der Figuren

**Fig. 1** zeigt eine schematische Darstellung eines Gitters in der Zugasleitung.
**Fig. 2** zeigt eine schematische Darstellung eines ausgeschnittenen Gitters.
**Fig. 3** zeigt eine schematische Darstellung eines gewobenen Gitters.
**Fig. 4** zeigt eine schematische Darstellung mit geklemmter Gitterscheibe am Austritt der Zugasleitung.
**Fig. 5** zeigt eine schematische Darstellung eines Gitters, befestigt mittels Stiften an einem geklemmten Ring. Das Gitter ist unterhalb des Austritts der Zugasleitung.
**Fig. 6** zeigt eine schematische Darstellung verschiedener Ausführungsformen eines an einer Düse befestigten Gitters.
**Fig. 7** zeigt eine schematische Darstellung eines zylindrischen Abgaskorbs.
**Fig. 8** zeigt eine schematische Darstellung eines kegelförmigen Abgaskorbs.

**Fig. 1** zeigt eine Bodenplatte **1** des Reaktors sowie eine Zugasleitung **2.** In die Zugasleitung **2** ist ein Gitter **3** eingebracht.

**Fig. 2** zeigt ein Gitter **3** mit ausgeschnittenen Öffnungen. Das Gitter **3** ergibt sich aus einem Grundkörper mit Löchern. Das Gitter **3** ist durch Maschenweite **a** und Steg breite **b** charakterisiert.

**Fig. 3** zeigt ein Gitter **3** mit Maschengewebe. Auch ein derartiges gewobenes Gitter **3** lässt sich durch Maschenweite **a** und Stegbreite **b** charakterisieren.

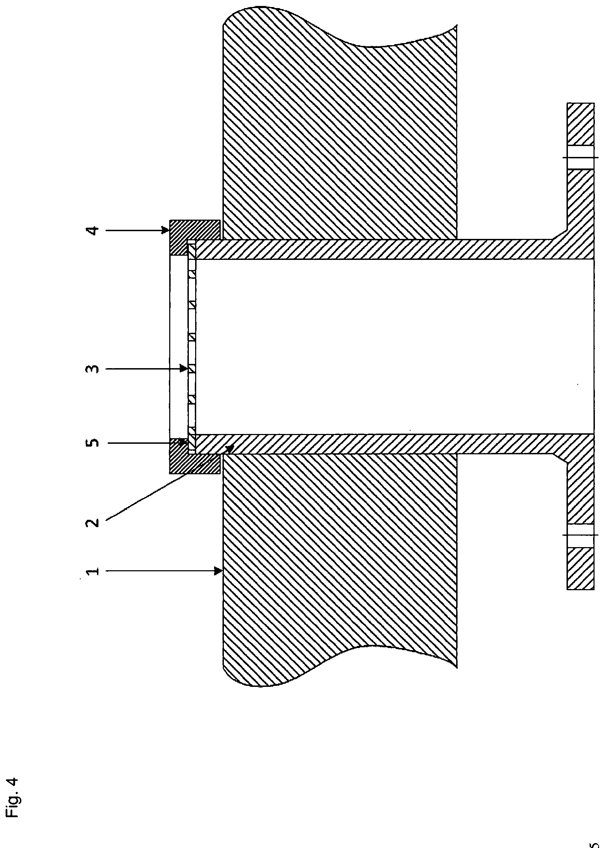

**Fig. 4** zeigt eine Bodenplatte **1** des Reaktors sowie eine Zugasleitung **2.** Am Austritt der Zugasleitung **2** ist ein Gitter **3** befestigt. Zu diesem Zweck ist ein Befestigungsring **5** für das Gitter **3** vorhanden, der mittels Verschraubung **4** an der Zugasleitung **2** fixiert ist. Daraus ergibt sich eine am Austritt der Zugasleitung **2** geklemmte Gitterscheibe.

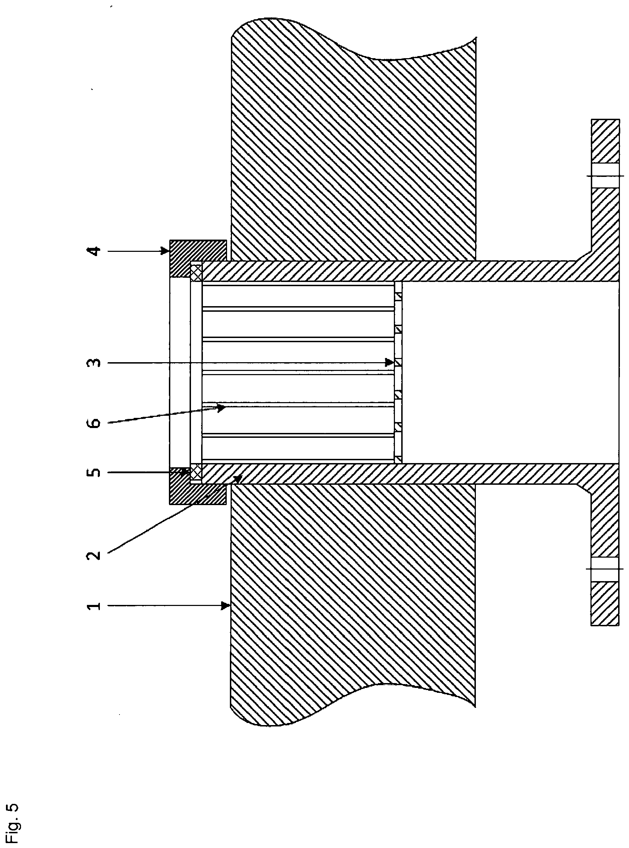

**Fig. 5** zeigt eine Bodenplatte **1** des Reaktors sowie eine Zugasleitung **2.** Am Austritt der Zugasleitung **2** ist ein Befestigungsring **5** mittels einer Verschraubung 4 an der Zugasleitung **2** fixiert. Das Gitter **3** befindet sich innerhalb der Zugasleitung 2 und ist mittels Stiften **6** am Befestigungsring befestigt. Daraus ergibt sich ein unterhalb des Austritts der Zugasleitung **2** befindliches an geklemmtem Ring **5** befestigtes Gitter **3**,

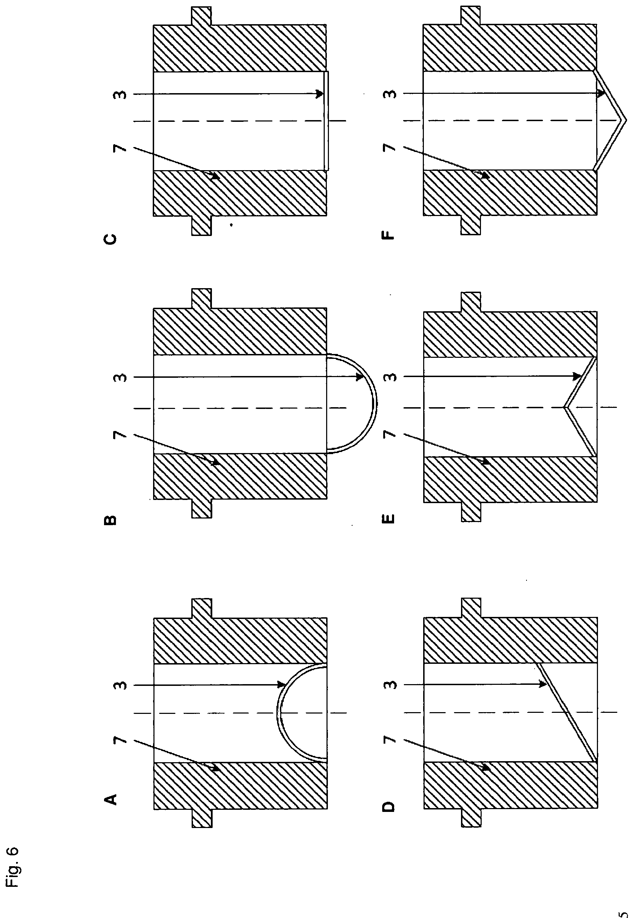

**Fig. 6** zeigt verschiedene Ausführungsformen eines an einer Düse 7 befestigten Gitters 3. Die Grundkörper der Gitter 3 welsen unterschiedliche Geometrien auf: kugelförmig / oval (A, B), eben (C, D) und konisch (E, F). Ausführung D ist in einem Winkel von ca 30° zur Strömungsrichtung in der Düse fixiert.

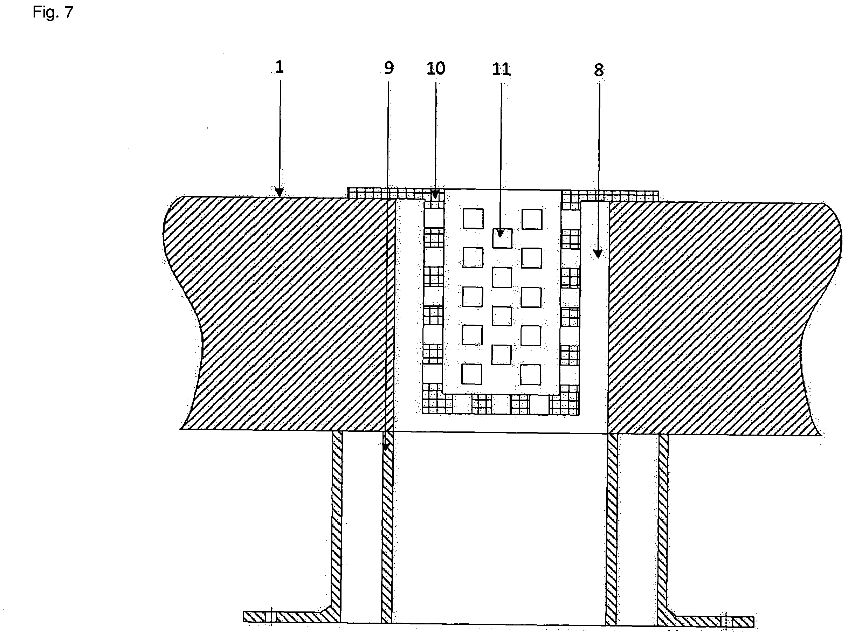

**Fig. 7** zeigt eine Bodenplatte **1** des Reaktors, eine Abgasöffnung **8** sowie eine Abgasleitung **9.** In die Abgasleitung **9** ist ein Abgaskorb **10** eingebracht. Der Abgaskorb **10** weist Löcher **11** auf. Der Abgaskorb **10** hat eine zylindrische Form.

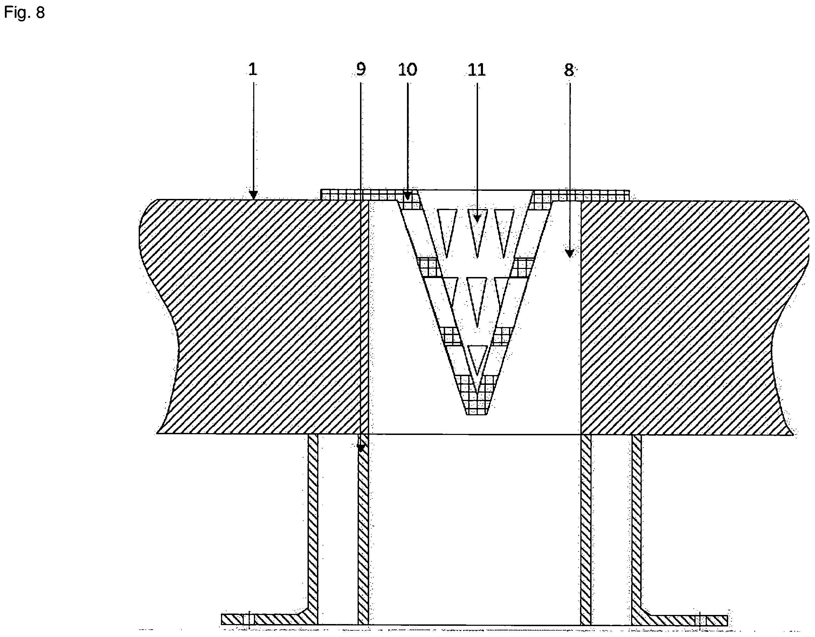

**Fig. 8** zeigt eine Bodenplatte 1 des Reaktors, eine Abgasöffnung **8** sowie eine Abgasleitung **9.** In die Abgasleitung **9** ist ein Abgaskorb **10** eingebracht. Der Abgaskorb **10** weist Löcher **11** auf. Der Abgaskorb **10** hat eine Kegelform.

### Vergleichsbeispiel

### Abscheidung mit Düsen ohne Gitter und ohne Abgaskorb (nicht erfindungsgemäß)

Bei ca. 10 % der Chargen wurden nach Endoskopieren der Zugas- und Abgasleitung Siliciumsplitter und -brocken gefunden. Diese mussten aufwendig entfernt werden. Dies hat die Rüstzeit um 4 Stunden verlängert.
Ein Teil der Siliciumsplitter und -brocken konnte trotz Endoskopieren nicht gefunden werden.

Dies hatte zur Folge, dass 4% der Folgechargen während des Prozesses ausgefallen sind. Ursache waren umfallende Stäbe.

Eine weitere Folge war, dass zwei Gruppen der Stabpaargewichtsverteilung erhalten wurden.

Bei der ersten Gruppe lag die Abweichung von dickstem zu dünnstem Stabpaar bezogen auf das mittlere Stabpaargewicht der Charge bei ca. 3%. Diese Gruppe war zu 80% vertreten und war frei von Siliciumsplitter und -brocken im Zugassystem.

Bei der zweiten Gruppe lag die Abweichung von dickstem zu dünnstem Stabpaar bezogen auf das mittlere Stabpaargewicht der Charge bei ca. 8%. Diese Gruppe war zu 20% vertreten. 25% des Materials aus dieser Gruppe musste wegen zu schlechter Morphologie abgewertet werden.

Auf Grund der schlechten Stabpaargewichtsverteilung wurde eine außerplanmäßige Revision (Abbau der Bodenplatte) durchgeführt. Dabei wurden Siliciumsplitter und - brocken im Zugassystem festgestellt und entfernt.

### Beispiel 1

### Abscheidung mit Düsen mit Gitter und ohne Abgaskorb

Auf Grund der Düsen mit Gitter können nur Siliciumsplitter- und brocken in das Zugassystem gelangen, die kleiner als die Maschenweite des Gitters sind. Diese können aber durch einfaches Rückspülen entfernt werden. Somit entfällt das aufwendige Endoskopieren und entfernen der Siliciumsplitter- und -brocken in der Zugasleitung.

Im Abgassystem können noch Si-Brocken, die durch Endoskopieren nicht gefunden werden, liegen und die Abgasleitung teilweise verblocken. Dadurch wurden wiederum zwei Gruppen der Stabpaargewichtsverteilung erhalten.

Bei der ersten Gruppe lag die Abweichung von dickstem zu dünnstem Stabpaar, bezogen auf das mittlere Stabpaargewicht der Charge, bei ca. 3%. Diese Gruppe war zu 90% vertreten und war frei von Siliciumsplitter und -brocken im Zugassystem und Abgassystem.

Bei der zweiten Gruppe lag die Abweichung von dickstem zu dünnstem Stabpaar bezogen, auf das mittlere Stabpaargewicht der Charge, bei ca. 6%. Diese Gruppe war zu 10% vertreten und hatte Splitter im Abgassystem. 15% des Materials aus dieser Gruppe musste wegen zu schlechter Morphologie abgewertet werden.

### Beispiel 2

### Abscheidung mit Düsen ohne Gitter und mit Abgaskorb

Auf Grund der Abgaskörbe in den Abgasöffnungen können nur Siliciumsplitter- und brocken in das Abgassystem gelangen, die kleiner als der Lochdurchmesser der Abgaskörbe sind. Diese können aber durch einfaches Rückspülen entfernt werden. Somit entfällt das aufwendige Endoskopieren und entfernen der Siliciumsplitter- und brocken in der Abgasleitung.

Im Zugassystem können noch Si-Brocken, die durch Endoskopieren nicht gefunden werden, liegen. dadurch wurden wiederum zwei Gruppen der Stabpaargewichtsverteilung erhalten.

Bei der ersten Gruppe lag die Abweichung von dickstem zu dünnstem Stabpaar bezogen auf das mittlere Stabpaargewicht der Charge bei ca. 3%. Diese Gruppe war zu 90% vertreten und war frei von Siliciumsplitter und -brocken im Zugassystem und Abgassystem.

Bei der zweiten Gruppe lag die Abweichung von dickstem zu dünnstem Stabpaar bezogen auf das mittlere Stabpaargewicht der Charge bei ca. 5%. Diese Gruppe war zu 10% vertreten und hatte Splitter im Zugassystem. 10% des Materials aus dieser Gruppe musste wegen zu schlechter Morphologie abgewertet werden.

### Beispiel 3

### Abscheidung mit Düsen mit Gitter und mit Abgaskorb

Auf Grund der Düsen mit Gitter und der Abgaskörbe in den Abgasöffnungen können nur Siliciumsplitter- und brocken in das Zugas - und Abgassystem gelangen, die kleiner als die Maschenweite der Gitter sind. Diese können aber durch einfaches Rückspülen entfernt werden. Somit entfällt das aufwendige Endoskopieren und Entfernen der Siliciumsplitter- und brocken in Zugas- und Abgasleitung.

Es wurde nur eine homogene Gruppe von Stabpaargewichtsverteilungen mit einer Abweichung von dickstem zu dünnstem Stabpaar bezogen auf das mittlere Stabpaargewicht der Charge von ca. 3% erhalten.

Materialabwertungen wegen zu schlechter Morphologie waren nicht notwendig.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

Daher sollen alle derartigen Abänderungen und Modifikationen sowie Äquivalente durch den Schutzbereich der Ansprüche abgedeckt sein.

## Patentansprüche

1. Reaktor zur Abscheidung von polykristallinem Silicium, der seitlich und nach oben durch eine Reaktorwand und nach unten durch eine Bodenplatte begrenzt ist, umfassend mehrere auf der Bodenplatte angebrachte, durch direkten Stromdurchgang beheizbare Filamentstäbe, ein durch eine oder mehrere Öffnungen der Bodenplatte geführtes Zugassystem zum Einbringen eines Silicium enthaltenden Reaktionsgasgemisches in den Reaktor, und ein durch ein oder mehrere Öffnungen der Bodenplatte geführtes Abgassystem zum Abführen von Abgas aus dem Reaktor, **dadurch gekennzeichnet, dass** Zugassystem und/oder Abgassystem wenigstens ein Schutzelement umfassen, das aus Metall, aus Keramik oder aus CFC besteht, das Öffnungen oder Maschen aufweist, wobei die Öffnungen und die Maschen des Schutzelements so konfiguriert sind, dass unterhalb des Schutzelements nur Siliciumteile in das Zugas- oder Abgassystem gelangen können, die sich durch Spülen aus dem Zugas- oder Abgassystem entfernen lassen, wobei das Zugassystem wenigstens eine Düse und wenigstens eine mit der Düse verbundene Zugasleitung umfasst und das Schutzelement in die Düse oder in die Zugasleitung eingebracht ist.

2. Reaktor nach Anspruch 1, wobei es sich beim Schutzelement um ein Gitter handelt, das in einem Abstand von 0 - 500 mm vom Ende der Zugasleitung entfernt eingebracht ist.

3. Reaktor nach Anspruch 2, wobei das Gitter an der Unterseite der Düse befestigt ist.

4. Reaktor nach einem der Ansprüche 1 bis 3, wobei ein Verhältnis K1 der Summe aller Lochflächen zur Gesamtfläche des Gitters zwischen 0,2 und 0,8 beträgt.

5. Reaktor nach einem der Ansprüche 1 bis 4, wobei das Abgassystem wenigstens eine Abgasleitung umfasst und es sich beim Schutzelement um ein Abgassieb handelt, das in der Abgasleitung oder in einer Öffnung der Bodenplatte für das Abgassystem platziert ist.

6. Reaktor nach einem der Ansprüche 1 bis 4, wobei es sich beim Schutzelement um einen Abgaskorb handelt, der in die Öffnung der Bodenplatte für das Abgassystem eingehängt ist.

7. Reaktor nach Anspruch 6, wobei der Abgaskorb nach oben zur Bodenplatte hin offen, nach unten zu einer Abgasleitung hin geschlossen und an dessen Wandung mit Löchern versehen ist.

8. Reaktor nach einem der Ansprüche 6 oder 7, wobei ein Verhältnis K2 der Summe aller Lochflächen zur in die Öffnung der Bodenplatte ragenden Oberfläche des Abgaskorbes zwischen 0,2 und 0,9 beträgt.

9. Verfahren zur Herstellung von polykristallinem Silicium, umfassend Einleiten eines Reaktionsgases enthaltend eine Silicium enthaltende Komponente und Wasserstoff in einen Reaktor nach einem der Ansprüche 1 bis 8, enthaltend mehrere Filamentstäbe, die jeweils mittels einer Elektrode mit Strom versorgt und damit durch direkten Stromdurchgang auf eine Temperatur aufgeheizt werden, bei der sich polykristallines Silicium auf den Filamentstäben abscheidet.

## Claims

1. Reactor for deposition of polycrystalline silicon which is delimited laterally and upwardly by a reactor wall and downwardly by a base plate, comprising a plurality of filament rods heatable by direct passage of current and attached to the base plate, a feed gas system passed through one or more openings in the base plate for introducing a silicon-containing reaction mixture into the reactor and an offgas system passed through one or more openings in the base plate for discharging offgas from the reactor, **characterized in that** the feed gas system and/or the offgas system comprise at least one protective element made of metal, of ceramic or of CFC which comprises openings or mesh apertures, wherein the openings and the mesh apertures of the protective element are configured such that only silicon pieces which may be removed from the feed gas or offgas system by flushing can get into the feed gas or offgas system below the protective element, wherein the feed gas system comprises at least one nozzle and at least one feed gas conduit connected to the nozzle and the protective element is installed in the nozzle or in the feed gas conduit.

2. Reactor according to Claim 1, wherein the protective element is a grid installed at a distance of 0 - 500 mm from the end of the feed gas conduit.

3. Reactor according to Claim 2, wherein the grid is secured to the underside of the nozzle.

4. Reactor according to any of Claims 1 to 3, wherein a ratio K1 of the sum of all hole areas to the total area of the grid K1 is between 0.2 and 0.8.

5. Reactor according to any of Claims 1 to 4, wherein the offgas system comprises at least one offgas conduit and the protective element is an offgas sieve placed in the offgas conduit or in an opening in the base plate for the offgas system.

6. Reactor according to any of Claims 1 to 4, wherein the protective element is an offgas basket suspended in the opening in the baseplate for the offgas system.

7. Reactor according to Claim 6, wherein the offgas basket is open in the upward direction toward base plate, closed in the downward direction toward the offgas conduit and provided with holes in its wall.

8. Reactor according to Claim 6 or 7, wherein a ratio K2 of the sum of all hole areas to the area of the offgas basket projecting into the opening in the base plate is between 0.2 and 0.9.

9. Process for producing polycrystalline silicon, comprising introducing a reaction gas containing a silicon-containing component and hydrogen into a reactor according to any of Claims 1 to 8 containing a plurality of filament rods which are each supplied with current by means of an electrode and thus heated by direct passage of current to a temperature at which polycrystalline silicon is deposited on the filament rods.

## Revendications

1. Réacteur pour le dépôt de silicium polycristallin, qui est délimité sur le côté et en haut par une paroi de réacteur et en bas par une plaque de fond, comprenant plusieurs tiges filamentaires pouvant être chauffées par passage direct de courant, disposées sur la plaque de fond, un système d'alimentation en gaz acheminé au travers d'une ou de plusieurs ouvertures de la plaque de fond pour l'introduction d'un mélange de gaz de réaction contenant du silicium dans le réacteur, et un système d'évacuation de gaz acheminé au travers d'une ou de plusieurs ouvertures de la plaque de fond pour l'évacuation d'un gaz d'échappement du réacteur, **caractérisé en ce que** le système d'alimentation en gaz et/ou le système d'évacuation de gaz comprennent au moins un élément de protection, qui est constitué par du métal, de la céramique ou du CFC, qui comprend des ouvertures ou des mailles, les ouvertures et les mailles de l'élément de protection étant configurées de telle sorte que seules des fractions de silicium qui peuvent être éliminées du système d'alimentation en gaz ou d'évacuation de gaz par rinçage puissent atteindre le système d'alimentation en gaz ou d'évacuation de gaz en dessous de l'élément de protection, le système d'alimentation en gaz comprenant au moins une buse et au moins un conduite d'alimentation en gaz raccordée avec la buse, et l'élément de protection étant disposé dans la buse ou dans la conduite d'alimentation en gaz.

2. Réacteur selon la revendication 1, dans lequel l'élément de protection consiste en une grille qui est disposée à une distance de 0 à 500 mm de l'extrémité de la conduite d'alimentation en gaz.

3. Réacteur selon la revendication 2, dans lequel la grille est fixée sur le côté inférieur de la buse.

4. Réacteur selon l'une quelconque des revendications 1 à 3, dans lequel un rapport K1 entre la somme de toutes les surfaces de trous et la surface totale de la grille est compris entre 0,2 et 0,8.

5. Réacteur selon l'une quelconque des revendications 1 à 4, dans lequel le système d'évacuation de gaz comprend au moins une conduite d'évacuation de gaz, et l'élément de protection consiste en un tamis d'évacuation de gaz, qui est placé dans la conduite d'évacuation de gaz ou dans une ouverture de la plaque de fond pour le système d'évacuation de gaz.

6. Réacteur selon l'une quelconque des revendications 1 à 4, dans lequel l'élément de protection consiste en une corbeille d'évacuation de gaz, qui est suspendue dans l'ouverture de la plaque de fond pour le système d'évacuation de gaz.

7. Réacteur selon la revendication 6, dans lequel la corbeille d'évacuation de gaz est ouverte en haut vers la plaque de fond, fermée en bas vers une conduite d'évacuation de gaz, et munie de trous sur sa paroi.

8. Réacteur selon l'une quelconque des revendications 6 ou 7, dans lequel un rapport K2 entre la somme de toutes les surfaces de trous et la surface de la corbeille d'évacuation de gaz dépassant dans l'ouverture de la plaque de fond est compris entre 0,2 et 0,9.

9. Procédé de fabrication de silicium polycristallin, comprenant l'introduction d'un gaz de réaction contenant un composant contenant du silicium et de l'hydrogène dans un réacteur selon l'une quelconque des revendications 1 à 8, contenant plusieurs tiges filamentaires, qui sont chacune alimentées avec un courant au moyen d'une électrode et sont ainsi portées par passage direct de courant à une température à laquelle du silicium polycristallin se dépose sur les tiges filamentaires.
